# EUROPEAN PATENT APPLICATION

(11) **EP 4 793 703 A1**
(43) Date of publication of application: **19.08.2026**
(21) Application number: 24877278.2
(22) Date of filing: 11.10.2024
(51) Int. Cl.: G03F 1/24, G03F 1/58, G03F 1/82

(54) **REFLECTIVE MASK BLANK AND REFLECTIVE MASK**

(30) Priority: 12.10.2023 JP 2023176857
(71) Applicant: Tekscend Photomask Corp., Tokyo 105-7133 (JP)
(72) Inventor: ICHIKAWA Kenjiro, Tokyo 105-7133 (JP); MIYAWAKI Daisuke, Tokyo 105-7133 (JP)
(74) Representative: TBK
(86) International application number: PCT/JP2024/036448
(87) International publication number: WO 2025/079684

(57) **Abstract**

An object of the present invention is to provide an EUV photomask blank and an EUV photomask having high resistance to hydrogen radicals, low EUV reflectivity, and a high OD value. A reflective mask blank (10) according to an embodiment at least includes a substrate (1), a multilayer reflective film (2), a capping layer (3), and a low-reflective portion (5). The low-reflective portion (5) is formed by alternately depositing a first absorption film (51) and a second absorption film (52). The first absorption film (51) has high hydrogen radical resistance. An extinction coefficient or a refractive index of the first absorption film (51) is different from an extinction coefficient or a refractive index of the second absorption film (52), and the extinction coefficient of the second absorption film (52) with respect to EUV light is 0.04 or more.

## Description

### TECHNICAL FIELD

The present invention relates to a reflective mask blank and a reflective mask used in production of a semiconductor device and the like.

### BACKGROUND ART

In a production process of a semiconductor device, a demand for miniaturization by photolithography technology has been increasing with miniaturization of the semiconductor device. In photolithography, a minimum development dimension of a transfer pattern greatly depends on a wavelength of an exposure light source, and a shorter wavelength enables a smaller minimum resolution dimension. For this reason, in the production process of the semiconductor device, an exposure light source in the related art using ArF excimer laser light having a wavelength of 193 nm has been undergoing replacement with an EUV exposure light source having a wavelength of 13.5 nm.

EUV light is a short wavelength, and most materials have high absorptivity of the EUV light. Thus, a photomask for EUV (EUV mask) is a reflective mask unlike transmissive masks in the related art (see, for example, Patent Literature 1 and Patent Literature 2). Patent Literature 1 discloses forming, in a reflective exposure mask used in EUV lithography, a multilayer film where two or more types of material layers are cyclically deposited on a base substrate, and then forming a pattern containing a metal film containing nitride or a mask pattern containing a deposited structure of a metal nitride film and a metal film on the multilayer film.

Patent Literature 2 discloses a reflective EUV mask including a phase control film and in which a high refractive index material layer and a low refractive index material layer are alternately deposited on the phase control film to form a deposited structure, as an absorber film deposited on a multilayer reflective film.

In EUV lithography, as described above, a refractive optical system using light transmission cannot be used, and an optical system member of an exposure apparatus is not a lens but a mirror. This causes a problem that incident light on the EUV photomask and reflected light from the EUV photomask cannot be designed coaxially. EUV lithography basically employs a technique of allowing EUV light to be incident with an optical axis tilted by 6 degrees from a direction perpendicular to the EUV photomask, and applying reflected light reflected at an angle of -6 degrees to a semiconductor substrate.

In this way, the optical axis is tilted in EUV lithography, and this may cause a problem called a "shadowing effect" of deteriorating transfer performance due to a shadow of a pattern (absorption layer pattern) of the EUV photomask by the EUV light incident on the EUV photomask.

To solve this problem, Patent Literature 1 discloses a method in which an extinction coefficient k with respect to EUV of a phase control film and a low refractive index material layer is adjusted to 0.03 or more to achieve an absorber layer having a film thickness thinner than that in the related art (60 nm or less) and the shadowing effect is reduced.

Patent Literature 2 discloses a method in which the high refractive index material layer and the low refractive index material are alternately deposited as an absorption film to achieve reflectivity of EUV light of 2% or less by an absorber layer having a film thickness thinner than that in the related art.

In a current EUV exposure apparatus, cleaning using hydrogen radicals is performed to reduce contamination in a chamber due to contamination. The photomask is exposed to a hydrogen radical environment, and a mask lifetime may be shortened when the photomask has a low durability against hydrogen radicals. For this reason, the photomask is required to be formed of a compound material having high hydrogen radical resistance.

However, in the methods in Patent Literature 1 and Patent Literature 2, the hydrogen radical resistance is not mentioned, and it is not clear whether the photomask can withstand long-term use.

### CITATION LIST

### PATENT LITERATURE

Patent Literature 1: JP6408790B
Patent Literature 2: JP6661724B

### SUMMARY OF INVENTION

### TECHNICAL PROBLEM

As described above, in the related art, there is no reflective mask blank and no reflective mask in which reflectivity of EUV is reduced (absorption is increased) and the resistance to hydrogen radicals is improved while minimizing the shadowing effect.

Therefore, an object of the present invention is to provide a reflective mask blank (EUV photomask blank) and a reflective mask (EUV photomask) that have high resistance to hydrogen radicals and exhibit, by minimizing the shadowing effect, excellent transferability. In other words, an object of the present invention is to provide an EUV photomask blank (reflective mask blank) and an EUV photomask (reflective mask) having high resistance to hydrogen radicals, low EUV reflectivity, and a high OD value.

### SOLUTION TO PROBLEM

A reflective mask blank according to one aspect of the present invention is a reflective mask blank used for producing a reflective mask for pattern transfer using extreme ultraviolet light as a light source, the reflective mask blank at least including: a substrate; a multilayer film formed on the substrate; a capping film formed on the multilayer film configured to protect the multilayer film; and an absorption film formed on the capping film, in which the absorption film is formed by alternately depositing a first absorption film and a second absorption film, the first absorption film has high hydrogen radical resistance, an extinction coefficient or a refractive index of the first absorption film is different from an extinction coefficient or a refractive index of the second absorption film, and the extinction coefficient of the second absorption film with respect to EUV light is 0.04 or more.

A reflective mask according to one aspect of the present invention is a reflective mask at least including: a substrate; a multilayer film formed on the substrate; a capping film formed on the multilayer film configured to protect the multilayer film; and an absorption film formed on the capping film and patterned, in which the absorption film is formed by alternately depositing a first absorption film and a second absorption film, the first absorption film has high hydrogen radical resistance, an extinction coefficient or a refractive index of the first absorption film is different from an extinction coefficient or a refractive index of the second absorption film, and the extinction coefficient of the second absorption film with respect to EUV light is 0.04 or more.

### ADVANTAGEOUS EFFECTS OF INVENTION

In one aspect of the present invention, alternately depositing a first absorption film having high hydrogen radical resistance and a second absorption film having an EUV extinction coefficient of 0.04 or more as absorption films allows for providing an EUV photomask blank (reflective mask blank) and an EUV photomask (reflective mask) that have high resistance to hydrogen radicals and exhibit, by minimizing a shadowing effect, excellent transferability. More specifically, in one aspect of the present invention, alternately depositing the first absorption film having high hydrogen radical resistance and the second absorption film having an EUV extinction coefficient of 0.04 or more as absorption films allows for providing an EUV photomask blank (reflective mask blank) and an EUV photomask (reflective mask) that have high resistance to hydrogen radicals, low EUV reflectivity, and a high OD value.

### BRIEF DESCRIPTION OF DRAWINGS

FIG. 1 is a cross-sectional view schematically illustrating a structure of a reflective photomask blank according to an embodiment of the present invention.
FIG. 2 is a cross-sectional view schematically illustrating a structure of a reflective photomask according to the embodiment of the present invention.
FIG. 3 is a graph illustrating optical constants of metals at an EUV light wavelength.
FIG. 4 is a conceptual diagram illustrating a method for evaluating a hydrogen radical resistance according to the present embodiment.
FIG. 5 is a cross-sectional view schematically illustrating a modification of the reflective photomask according to the embodiment of the present invention.

### DESCRIPTION OF EMBODIMENTS

An embodiment of the present invention will be described with reference to the drawings.

Here, a structure illustrated in the drawings is schematic, and a relationship between a thickness and a planar dimension, a ratio of a thickness of each layer, and the like are different from actual ones. In addition, the embodiments described below exemplifies a configuration for embodying the technical concept of the present invention, and the technical concept of the present invention is not limited to materials, shapes, structures, and the like of the components described below. Various modifications can be made to the technical concept of the present invention within the technical scope defined by the claims.

### (Configuration of Reflective Photomask)

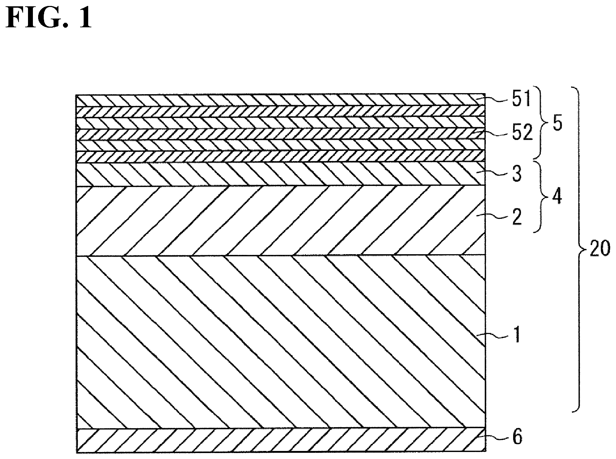

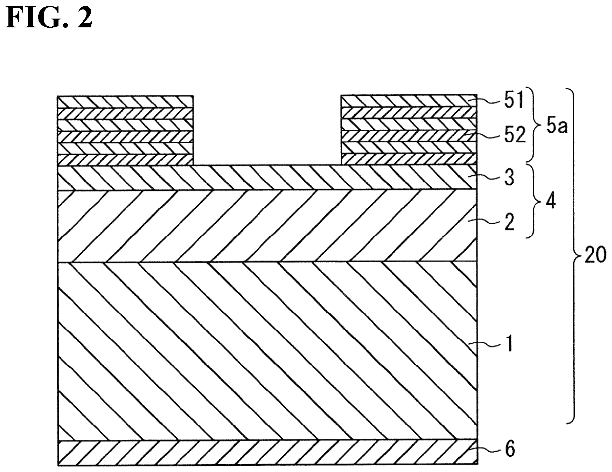

Basic configurations of a reflective photomask blank (reflective mask blank) and a reflective photomask (reflective mask) according to the embodiment of the present invention will be described with reference to FIGs. 1 and 2.

FIG. 1 is a schematic cross-sectional view illustrating a reflective photomask blank 10 according to the embodiment of the present invention. FIG. 2 is a schematic cross-sectional view illustrating a reflective photomask 20 according to the embodiment of the present invention. Here, the reflective photomask 20 according to the embodiment of the present invention illustrated in FIG. 2 is formed by patterning a reflective layer 4 of the reflective photomask blank 10 according to the embodiment of the present invention illustrated in FIG. 1.

The reflective photomask blank 10 according to the embodiment of the present invention is a reflective photomask blank used for producing a reflective photomask for pattern transfer using extreme ultraviolet light as a light source, and at least includes a substrate (low thermal expansion film) 1, a multilayer reflective film (multilayer film) 2 formed on the substrate 1, a capping film (capping layer) 3 formed on the multilayer reflective film 2 configured to protect the multilayer reflective film 2, and a low-reflective portion (absorption film) 5 formed on the capping film 3.

The low-reflective portion 5 is a multilayer structure in which a first absorption film 51 and a second absorption film 52 are alternately deposited. The first absorption film 51 is a layer formed of a material having high hydrogen radical resistance. An extinction coefficient or a refractive index of the first absorption film 51 is different from an extinction coefficient or a refractive index of the second absorption film 52. Further, the extinction coefficient of the second absorption film 52 with respect to EUV light is 0.04 or more.

Hereinafter, each configuration of the reflective photomask blank 10 and the reflective photomask 20 will be described in detail.

As illustrated in FIG. 1, the reflective photomask blank 10 according to the embodiment of the present invention includes the multilayer reflective film 2 on the substrate 1 and the capping layer 3 on the multilayer reflective film 2. Accordingly, the reflective layer 4 having the multilayer reflective film 2 and the capping layer 3 is formed on the substrate 1.

The low-reflective portion 5 is provided on the reflective layer 4. The low-reflective portion 5 is, for example, a multilayer structure including four or more layers, and includes the first absorption film 51 having high hydrogen radical resistance as a first layer and the second absorption film 52 having an extinction coefficient of 0.04 or more as a second layer, alternately.

### (Substrate)

As the substrate 1 according to the embodiment of the present invention, a flat Si substrate, a synthetic quartz substrate, or the like can be used. In addition, low thermal expansion glass to which titanium is added can be used, and the present invention is not limited thereto as long as a material having a low coefficient of thermal expansion is used.

### (Multilayer Reflective Film)

The multilayer reflective film 2 according to the embodiment of the present invention reflects extreme ultraviolet light (EUV light), which is exposure light, and is formed of a multilayer film of a combination of materials having significantly different refractive indices with respect to EUV light. For example, the multilayer reflective film 2 can be formed by repeatedly depositing layer pairs such as molybdenum (Mo) and silicon (Si), or molybdenum (Mo) and beryllium (Be), for about 40 periods.

### (Capping Layer)

The capping layer (capping film) 3 according to the embodiment of the present invention is formed of a material having resistance to dry etching performed when a low-reflective portion pattern 5a is formed, and functions as an etching stopper to prevent damage to the multilayer reflective film 2 when the low-reflective portion pattern 5a is formed by etching. Here, the capping layer 3 may be omitted depending on a material of the multilayer reflective film 2 and etching conditions.

In addition, a backside conductive film 6 may be formed on a surface of the substrate 1 on which the multilayer reflective film 2 is not formed. The backside conductive film 6 is a film for fixing the reflective photomask 20 using a principle of an electrostatic chuck when the reflective photomask 20 is set in an exposure apparatus.

### (Low-reflective Portion)

The low-reflective portion pattern 5a is formed by removing a part of the low-reflective portion 5 of the reflective photomask blank 10. In EUV lithography, EUV light is obliquely incident and reflected by the reflective layer 4, and due to a shadowing effect in which the low-reflective portion pattern 5a obstructs an optical path, performance of transfer onto a wafer deteriorates. Such deterioration of the transfer performance is reduced by reducing a thickness of the low-reflective portion 5 (low-reflective portion pattern 5a) that absorbs EUV light. Reducing the thickness of the low-reflective portion 5 (low-reflective portion pattern 5a) is achieved by employing, for the second absorption film 52, a material having high absorptivity with respect to EUV light, that is, a material having a high extinction coefficient k with respect to a wavelength of 13.5 nm, by employing, for the first absorption film 51, a film having an extinction coefficient or a refractive index different from that of the second absorption film 52, and by alternately depositing the films.

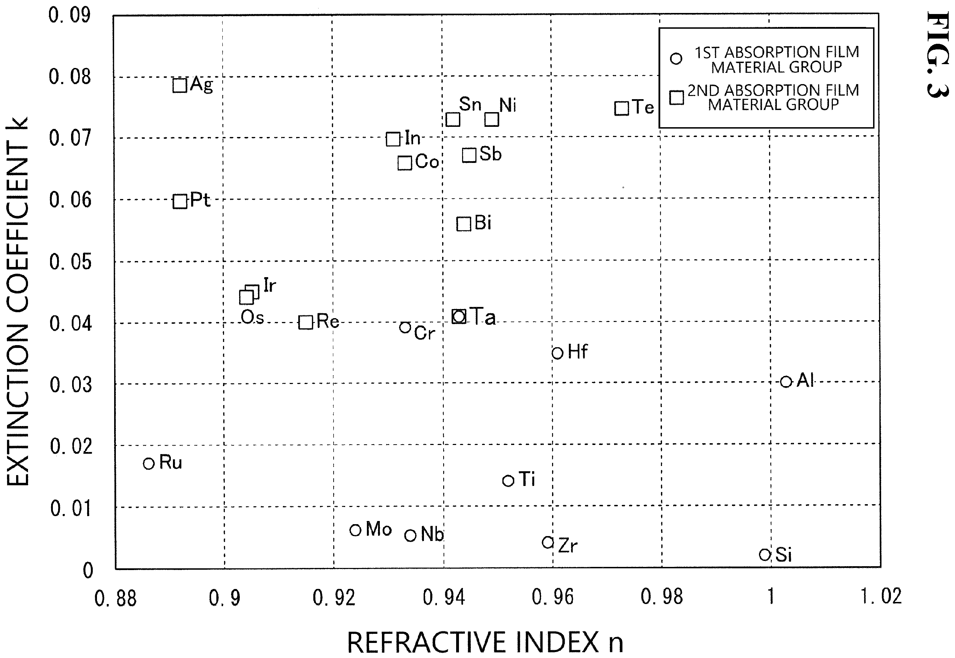

In the present embodiment, the phrase "the extinction coefficient k is high" means that the extinction coefficient k is 0.04 or more. Forming the second absorption film 52 with a compound material having an extinction coefficient k of 0.04 or more allows a thickness of the second absorption film 52 to be reduced, and this allows the thickness of the low-reflective portion 5 to be reduced. Examples of the compound material having an extinction coefficient k of 0.04 or more include materials illustrated in FIG. 3. Examples of the compound material having an extinction coefficient k of 0.04 or more (second absorption film material group) include materials containing one or more elements selected from tin, indium, platinum, nickel, tellurium, silver, cobalt, tantalum, antimony, bismuth, osmium, iridium, and rhenium, as illustrated in FIG. 3.

FIG. 3 shows examples of materials containing one or more elements selected from tantalum, silicon, titanium, niobium, chromium, hafnium, ruthenium, molybdenum, aluminum, and zirconium, as a group of materials having high hydrogen radical resistance (first absorption film material group).

Using a group of materials having high hydrogen radical resistance as the material of the first absorption film 51 constituting the low-reflective portion 5 of the present embodiment allows hydrogen radical resistance of the entire low-reflective portion 5 to be increased.

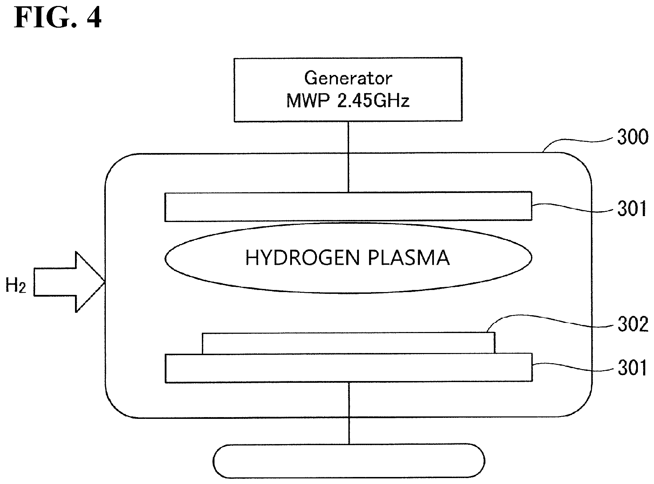

In the present embodiment, the term "material having high hydrogen radical resistance" means, for example, a compound material in which a film loss is 1 nm or less in a hydrogen radical environment excited under conditions in which an apparatus illustrated in FIG. 4 is used, a hydrogen flow rate is 100 sscm, 2.45 GHz microwave plasma (MWP) is applied, and a distance between electrodes 301 is set to 18 mm. The term "film (layer) having excellent hydrogen radical resistance" means a film (layer) in which a film loss is 1 nm or less in the hydrogen radical environment described above.

The first absorption film 51 preferably contains one or more elements selected from tantalum, silicon, titanium, niobium, chromium, hafnium, ruthenium, molybdenum, aluminum, and zirconium. If the first absorption film 51 contains the above elements, excellent hydrogen radical resistance can be imparted to the first absorption film 51.

In addition, an outermost layer of the low-reflective portion 5 is preferably the first absorption film 51. If the outermost layer of the low-reflective portion 5 is the first absorption film 51, excellent hydrogen radical resistance can be imparted to the entire low-reflective portion 5.

The second absorption film 52 preferably contains one or more elements selected from tin, indium, platinum, nickel, tellurium, silver, cobalt, tantalum, antimony, bismuth, osmium, iridium, and rhenium. If the second absorption film 52 contains the above elements, the extinction coefficient k of the second absorption film 52 is greater than 0.04, and the shadowing effect can be reduced.

When the above-described materials having high hydrogen radical resistance are also mixed into the second absorption film 52, the hydrogen radical resistance can be further improved, which is more preferable. In this case, there is no particular problem as long as the extinction coefficient k of the entire low-reflective portion 5 is 0.04 or more. In addition, there is no particular problem as long as the extinction coefficient k of the second absorption film 52 is 0.04 or more.

In the present embodiment, the extinction coefficient and the refractive index of each absorption film may be adjusted by appropriately adjusting the composition ratios of materials constituting each absorption film.

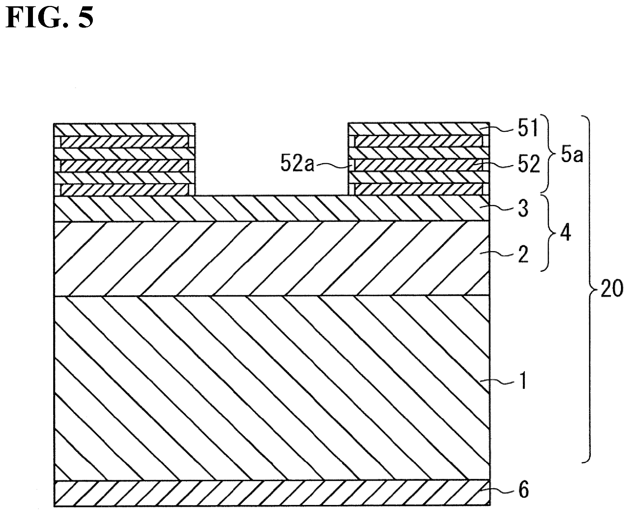

Further, if it is necessary to suppress damage due to hydrogen radicals on a sidewall of the low-reflective portion pattern 5a, a passivation treatment may be performed. By the passivation treatment, as illustrated in FIG. 5, a passivation layer 52a having high hydrogen radical resistance can be formed on a pattern sidewall of the second absorption film 52, and the hydrogen radical resistance can be further improved. For example, the material having high hydrogen radical resistance (high hydrogen radical resistance material) constituting the first absorption film 51 may be added to the second absorption film 52, and an oxide film (passivation layer 52a) may be formed on the pattern sidewall of the second absorption film 52. A content of the high hydrogen radical resistance material added to the second absorption film 52 is not limited as long as the extinction coefficient k of the second absorption film 52 is 0.04 or more.

A film thickness (specifically, a thickness from the pattern sidewall) of this thin film layer (passivation layer 52a) is preferably in a range of 0.5 nm or more and 8 nm or less from the viewpoint of improving resistance, more preferably the film thickness is in a range of 0.5 nm or more and 5 nm or less from the viewpoint of improving transferability, and still more preferably the film thickness is in a range of 2 nm or more and 5 nm or less from the viewpoint of improving both the resistance and the transferability.

One example of methods for forming the passivation layer 52a formed on the pattern sidewall of the second absorption film 52 is a treatment method using a treatment with a chemical solution such as SPM or APM. In the treatment method, a chemical solution other than those described above or a gas may be used. In addition, the passivation layer 52a may be an oxide film, and the oxide film may be formed by the above-described method or natural oxidation.

The thickness of the passivation layer 52a may be increased on the second absorption film 52 close to the capping layer 3 side and decreased on the second absorption film 52 close to an outermost surface side of the low-reflective portion 5.

In addition, the thickness of the passivation layer 52a may be decreased on the second absorption film 52 close to the capping layer 3 side and increased on the second absorption film 52 close to the outermost surface side of the low-reflective portion 5.

The thickness of the passivation layer 52a may be adjusted by appropriately adjusting a time of the treatment described above or a type of a treatment agent.

It is necessary to adjust a mixing ratio of the materials forming the low-reflective portion 5 such that a total film thickness of the low-reflective portion 5 is 47 nm or less to reduce the shadowing effect, and such that an OD value is 1.5 or more to maintain a contrast sufficient for pattern transfer. A lower limit of the mixing ratio depends on optical constants of the materials to be mixed and thus cannot be determined universally. To reduce the shadowing effect as compared to a film in the related art, it is desirable that the material group forming the second absorption film 52 is a compound material containing at least 50 atom% or more of the elements, excluding non-metal elements. Further, in order to transfer a fine pattern, an intensity contrast between light reflected by the reflective layer 4 and light reflected by the low-reflective portion 5 is desirably high. Therefore, the OD value of the low-reflective portion 5 is more preferably 2.0 or more.

Here, the optical density (OD) value, which is an indicator representing the light intensity contrast between the reflective layer 4 and the low-reflective portion 5, will be described. When intensity of the light reflected from the reflective layer 4 is Rm and intensity of the light reflected from the low-reflective portion 5 is Ra, the OD value is defined by the following equation (1).$OD = - log \left(Ra/Rm\right)$ ...

A higher OD value provides better contrast and enables high transferability. In the reflective photomask, OD > 1 is required for pattern transfer, and the OD value is more preferably 1.5 or more in order to obtain higher transfer performance than that of a film in the related art.

In the present embodiment, the number of layers of the first absorption film 51 and the second absorption film 52 is desirably four or more. When the number of layers is four or more, various combinations of materials and film thicknesses that can realize a reduced film thickness are possible. In addition, when the number of layers is in a range of 4 or more and 40 or less, film thickness can be sufficiently reduced, and when the number of layers is in a range of 4 or more and 16 or less, more combinations of materials and film thicknesses are possible, which is more preferable.

A refractive index of the constituent material of the first absorption film 51 is preferably in a range of 0.85 or more and 1 or less. The refractive index of the constituent material of the first absorption film 51 is more desirably different from that of the constituent material of the second absorption film 52 from the viewpoint of the number of combinations of materials.

The refractive index of the constituent material of the first absorption film 51 may be greater or less than the refractive index of the constituent material of the second absorption film 52.

Needless to say, the refractive index of the constituent material of the first absorption film 51 may be the same as the refractive index of the constituent material of the second absorption film 52.

The extinction coefficient k of the constituent material of the first absorption film 51 is more desirably different from the extinction coefficient k of the constituent material of the second absorption film 52 from the viewpoint of the number of combinations of materials.

The extinction coefficient k of the constituent material of the first absorption film 51 may be greater or less than the extinction coefficient k of the constituent material of the second absorption film 52.

Needless to say, the extinction coefficient k of the constituent material of the first absorption film 51 may be the same as the extinction coefficient k of the constituent material of the second absorption film 52.

A film thickness of each absorption film may be 0.1 nm or more. The film thickness of the low-reflective portion 5 is not limited as long as a film thickness of the first absorption film 51 and a film thickness of the second absorption film 52 are combined such that a total film thickness of the absorption films is 47 nm or less and the OD value is 1.5 or more.

For example, the film thickness of the first absorption film 51 and the film thickness of the second absorption film 52 may be the same.

Alternatively, the film thickness of the first absorption film 51 may be less than the film thickness of the second absorption film 52.

Alternatively, the film thickness of the first absorption film 51 may be greater than the film thickness of the second absorption film 52.

The film thickness of each absorption film may be gradually reduced or increased in a direction away from the capping layer 3 side (toward the outermost surface side of the low-reflective portion 5).

### [Examples]

Hereinafter, the present invention will be described in more detail with reference to examples, but the present invention is not limited by these examples in any way.

### <Example 1>

A synthetic quartz substrate having low thermal expansivity was used as a substrate. On the substrate, a multilayer reflective film was formed by stacking 40 stacks, each stack including a pair of silicon (Si) and molybdenum (Mo). A film thickness of the multilayer reflective film was set to 280 nm.

Next, a capping layer was deposited on the multilayer reflective film using ruthenium (Ru) so that the capping layer had a film thickness of 2.5 nm.

A second absorption film was deposited on the capping layer using tin oxide (SnO) and tantalum (Ta). In this case, the absorption film was formed so that the absorption film had a film thickness (single layer) of 11.4 nm. The second absorption film thus formed had a refractive index n of 0.95 and an extinction coefficient k of 0.050.

Next, a first absorption film was formed on the second absorption film using tantalum oxide (TaO). In this case, the absorption film was formed so that the absorption film had a film thickness (single layer) of 1.9 nm. The first absorption film thus formed had a refractive index n of 0.96 and an extinction coefficient k of 0.027.

Next, the first absorption film and the second absorption film were alternately deposited to form an absorption film having a total number of layers of six (a multilayer structure including three layers of the first absorption film and three layers of the second absorption film). A total film thickness of the entire absorption film thus formed was 39.9 nm.

Next, on a side of the substrate where the multilayer reflective film was not formed, a backside conductive film was formed by depositing chromium nitride (CrN) so that the backside conductive film had a thickness of 100 nm.

Thus, a reflective photomask blank according to Example 1 was prepared.

A multi-target sputtering apparatus was used for the deposition of each film on the substrate. The film thickness of each film was controlled by a sputtering time.

Next, a resist film was formed by depositing a positive chemically amplified resist (SEBP9012: manufactured by Shin-Etsu Chemical Co., Ltd.) on the absorption film to a film thickness of 120 nm by spin coating, followed by baking at 110°C for 10 minutes.

Next, a predetermined pattern was drawn on the positive chemically amplified resist by an electron beam lithography apparatus (JBX3030: manufactured by JEOL Ltd.).

Thereafter, the resist was subjected to a baking treatment at 110°C for 10 minutes, and then subjected to spray development (SFG3000: manufactured by Sigmameltec Ltd.). Accordingly, a resist pattern was formed.

Next, using the resist pattern as an etching mask, each absorption film was patterned by dry etching mainly using a chlorine-based gas to form an absorption film pattern.

Next, the remaining resist pattern was peeled off. Thus, an absorption film pattern where a surface and a sidewall of the absorption film were exposed was formed.

In this example, the absorption layer pattern was a line-and-space (L/S) pattern having a line width of 200 nm.

Accordingly, a reflective photomask according to Example 1 was prepared.

For the absorption film of Example 1, the reflectivity Rm of a multilayer reflective film region and the reflectivity Ra of an absorption film region were measured by a reflectivity measurement apparatus using EUV light. Based on measurement results, as a result of calculating an OD value, which is a mask characteristic, it was found that the EUV reflectivity in the absorption film region was 0.70% and the OD value was 1.96, as shown in Table 1.

### <Example 2>

A reflective photomask blank and a reflective photomask according to Example 2 were prepared in the same manner as in Example 1 except that the film thickness of the second absorption film (single layer) was 11.1 nm and the film thickness of the first absorption film (single layer) formed using silicon oxide (SiO) was 2.5 nm.

The refractive index n of the first absorption film was 0.97, and the extinction coefficient k was 0.013.

The total film thickness of the entire absorption film was 40.8 nm.

The EUV reflectivity in the absorption film region was 0.74%, and the OD value was 1.94.

### <Example 3>

A reflective photomask blank and a reflective photomask according to Example 3 were prepared in the same manner as in Example 1 except that the film thickness of the second absorption film (single layer) was 10.9 nm and the film thickness of the first absorption film (single layer) formed using titanium oxide (TiO) was 2.5 nm.

The refractive index n of the first absorption film was 0.94, and the extinction coefficient k was 0.022.

The total film thickness of the entire absorption film was 40.2 nm.

The EUV reflectivity in the absorption film region was 0.63%, and the OD value was 2.01.

### <Example 4>

A reflective photomask blank and a reflective photomask according to Example 4 were prepared in the same manner as in Example 1 except that the film thickness of the second absorption film (single layer) was 11.0 nm and the film thickness of the first absorption film (single layer) formed using niobium oxide (NbO) was 2.4 nm.

The refractive index n of the first absorption film was 0.95, and the extinction coefficient k was 0.010.

The total film thickness of the entire absorption film was 40.2 nm.

The EUV reflectivity in the absorption film region was 0.61%, and the OD value was 2.02.

### <Example 5>

A reflective photomask blank and a reflective photomask according to Example 5 were prepared in the same manner as in Example 1 except that the film thickness of the second absorption film (single layer) was 10.8 nm and the film thickness of the first absorption film (single layer) formed using chromium oxide (CrO) was 2.6 nm.

The refractive index n of the first absorption film was 0.93, and the extinction coefficient k was 0.033.

The total film thickness of the entire absorption film was 40.2 nm.

The EUV reflectivity in the absorption film region was 0.67%, and the OD value was 1.99.

### <Example 6>

A reflective photomask blank and a reflective photomask according to Example 6 were prepared in the same manner as in Example 1 except that the film thickness of the second absorption film (single layer) was 11.1 nm and the film thickness of the first absorption film (single layer) formed using hafnium oxide (HfO) was 2.2 nm.

The refractive index n of the first absorption film was 0.95, and the extinction coefficient k was 0.034.

The total film thickness of the entire absorption film was 39.9 nm.

The EUV reflectivity in the absorption film region was 0.72%, and the OD value was 1.95.

### <Example 7>

A reflective photomask blank and a reflective photomask according to Example 7 were prepared in the same manner as in Example 1 except that the film thickness of the second absorption film (single layer) was 10.4 nm and the film thickness of the first absorption film (single layer) formed using ruthenium (Ru) was 2.6 nm.

The refractive index n of the first absorption film was 0.89, and the extinction coefficient k was 0.017.

The total film thickness of the entire absorption film was 39.0 nm.

The EUV reflectivity in the absorption film region was 0.71%, and the OD value was 1.96.

### <Example 8>

A reflective photomask blank and a reflective photomask according to Example 8 were prepared in the same manner as in Example 1 except that the film thickness of the second absorption film (single layer) was 11.0 nm and the film thickness of the first absorption film (single layer) formed using molybdenum (Mo) was 2.4 nm.

The refractive index n of the first absorption film was 0.92, and the extinction coefficient k was 0.006.

The total film thickness of the entire absorption film was 40.2 nm.

The EUV reflectivity in the absorption film region was 0.37%, and the OD value was 2.25.

### <Example 9>

A reflective photomask blank and a reflective photomask according to Example 9 were prepared in the same manner as in Example 1 except that the film thickness of the second absorption film (single layer) was 11.3 nm and the film thickness of the first absorption film (single layer) formed using zirconium (Zr) was 2.1 nm.

The refractive index n of the first absorption film was 0.96, and the extinction coefficient k was 0.004.

The total film thickness of the entire absorption film was 40.2 nm.

The EUV reflectivity in the absorption film region was 0.54%, and the OD value was 2.08.

### <Example 10>

A reflective photomask blank and a reflective photomask according to Example 10 were prepared in the same manner as in Example 1 except that the film thickness of the second absorption film (single layer) formed using indium (In) and tantalum (Ta) was 11.5 nm, and the film thickness of the first absorption film (single layer) formed using niobium oxide (NbO) and silicon (Si) was 2.2 nm.

The refractive index n of the first absorption film was 0.95, and the extinction coefficient k was 0.015.

The refractive index n of the second absorption film was 0.94, and the extinction coefficient k was 0.058.

The total film thickness of the entire absorption film was 41.1 nm.

The EUV reflectivity in the absorption film region was 0.13%, and the OD value was 2.71.

### <Example 11>

A reflective photomask blank and a reflective photomask according to Example 11 were prepared in the same manner as in Example 1 except that the film thickness of the second absorption film (single layer) formed using nickel (Ni) and tantalum (Ta) was 11.2 nm, and the film thickness of the first absorption film (single layer) formed using niobium oxide (NbO) and silicon (Si) was 2.4 nm.

The refractive index n of the first absorption film was 0.95, and the extinction coefficient k was 0.015.

The refractive index n of the second absorption film was 0.95, and the extinction coefficient k was 0.053.

The total film thickness of the entire absorption film was 40.8 nm.

The EUV reflectivity in the absorption film region was 0.44%, and the OD value was 2.17.

### <Example 12>

A reflective photomask blank and a reflective photomask according to Example 12 were prepared in the same manner as in Example 1 except that the film thickness of the second absorption film (single layer) formed using tellurium (Te) and tantalum (Ta) was 10.9 nm, and the film thickness of the first absorption film (single layer) formed using niobium oxide (NbO) and silicon (Si) was 2.3 nm.

The refractive index n of the first absorption film was 0.95, and the extinction coefficient k was 0.015.

The refractive index n of the second absorption film was 0.96, and the extinction coefficient k was 0.057.

The total film thickness of the entire absorption film was 39.6 nm.

The EUV reflectivity in the absorption film region was 0.20%, and the OD value was 2.51.

### <Example 13>

A reflective photomask blank and a reflective photomask according to Example 13 were prepared in the same manner as in Example 1 except that the film thickness of the second absorption film (single layer) formed using silver (Ag) and tantalum (Ta) was 11.4 nm, and the film thickness of the first absorption film (single layer) formed using niobium oxide (NbO) and silicon (Si) was 2.6 nm.

The refractive index n of the first absorption film was 0.95, and the extinction coefficient k was 0.015.

The refractive index n of the second absorption film was 0.92, and the extinction coefficient k was 0.060.

The total film thickness of the entire absorption film was 42.0 nm.

The EUV reflectivity in the absorption film region was 0.06%, and the OD value was 3.05.

### <Example 14>

A reflective photomask blank and a reflective photomask according to Example 14 were prepared in the same manner as in Example 1 except that the film thickness of the second absorption film (single layer) formed using cobalt (Co) and tantalum (Ta) was 11.1 nm, and the film thickness of the first absorption film (single layer) formed using niobium oxide (NbO) and silicon (Si) was 2.4 nm.

The refractive index n of the first absorption film was 0.95, and the extinction coefficient k was 0.015.

The refractive index n of the second absorption film was 0.94, and the extinction coefficient k was 0.051.

The total film thickness of the entire absorption film was 40.5 nm.

The EUV reflectivity in the absorption film region was 0.55%, and the OD value was 2.07.

### <Example 15>

A reflective photomask blank and a reflective photomask according to Example 15 were prepared in the same manner as in Example 1 except that the film thickness of the second absorption film (single layer) formed using antimony (Sb) and tantalum (Ta) was 11.1 nm, and the film thickness of the first absorption film (single layer) formed using niobium oxide (NbO) and silicon (Si) was 2.5 nm.

The refractive index n of the first absorption film was 0.95, and the extinction coefficient k was 0.015.

The refractive index n of the second absorption film was 0.94, and the extinction coefficient k was 0.053.

The total film thickness of the entire absorption film was 40.8 nm.

The EUV reflectivity in the absorption film region was 0.41%, and the OD value was 2.20.

### <Example 16>

A reflective photomask blank and a reflective photomask according to Example 16 were prepared in the same manner as in Example 1 except that the film thickness of the second absorption film (single layer) formed using bismuth (Bi) and tantalum (Ta) was 11.1 nm, and the film thickness of the first absorption film (single layer) formed using niobium oxide (NbO) and silicon (Si) was 2.5 nm.

The refractive index n of the first absorption film was 0.95, and the extinction coefficient k was 0.015.

The refractive index n of the second absorption film was 0.94, and the extinction coefficient k was 0.049.

The total film thickness of the entire absorption film was 40.8 nm.

The EUV reflectivity in the absorption film region was 0.70%, and the OD value was 1.97.

### <Example 17>

A reflective photomask blank and a reflective photomask according to Example 17 were prepared in the same manner as in Example 1 except that the film thickness of the second absorption film (single layer) formed using iridium (Ir) and tantalum (Ta) was 11.8 nm, and the film thickness of the first absorption film (single layer) formed using niobium oxide (NbO) and silicon (Si) was 2.0 nm.

The refractive index n of the first absorption film was 0.95, and the extinction coefficient k was 0.015.

The refractive index n of the second absorption film was 0.93, and the extinction coefficient k was 0.043.

The total film thickness of the entire absorption film was 41.4 nm.

The EUV reflectivity in the absorption film region was 1.13%, and the OD value was 1.76.

### <Example 18>

A reflective photomask blank and a reflective photomask according to Example 18 were prepared in the same manner as in Example 1 except that the film thickness of the second absorption film (single layer) formed using rhenium (Re) and tantalum (Ta) was 11.7 nm, and the film thickness of the first absorption film (single layer) formed using niobium oxide (NbO) and silicon (Si) was 2.0 nm.

The refractive index n of the first absorption film was 0.95, and the extinction coefficient k was 0.015.

The refractive index n of the second absorption film was 0.93, and the extinction coefficient k was 0.040.

The total film thickness of the entire absorption film was 41.1 nm.

The EUV reflectivity in the absorption film region was 1.57%, and the OD value was 1.61.

### <Example 19>

A reflective photomask blank and a reflective photomask according to Example 19 were prepared in the same manner as in Example 1 except that the film thickness of the second absorption film (single layer) formed using platinum (Pt) and tantalum (Ta) was 11.9 nm, and the film thickness of the first absorption film (single layer) formed using niobium oxide (NbO) and silicon (Si) was 2.1 nm.

The refractive index n of the first absorption film was 0.95, and the extinction coefficient k was 0.015.

The refractive index n of the second absorption film was 0.92, and the extinction coefficient k was 0.050.

The total film thickness of the entire absorption film was 42.0 nm.

The EUV reflectivity in the absorption film region was 0.38%, and the OD value was 2.24.

### <Example 20>

A reflective photomask blank and a reflective photomask according to Example 20 were prepared in the same manner as in Example 1 except that the film thickness of the second absorption film (single layer) formed using osmium (Os) and tantalum (Ta) was 11.8 nm, and the film thickness of the first absorption film (single layer) formed using niobium oxide (NbO) and silicon (Si) was 2.0 nm.

The refractive index n of the first absorption film was 0.95, and the extinction coefficient k was 0.015.

The refractive index n of the second absorption film was 0.93, and the extinction coefficient k was 0.042.

The total film thickness of the entire absorption film was 41.4 nm.

The EUV reflectivity in the absorption film region was 1.19%, and the OD value was 1.73.

### <Example 21>

A reflective photomask blank and a reflective photomask according to Example 21 were prepared in the same manner as in Example 1 except that the film thickness of the second absorption film (single layer) formed using tin oxide (SnO) and tantalum (Ta) was 3.4 nm, and the film thickness of the first absorption film (single layer) formed using niobium oxide (NbO) and silicon (Si) was 3.5 nm.

The refractive index n of the first absorption film was 0.95, and the extinction coefficient k was 0.015.

The refractive index n of the second absorption film was 0.95, and the extinction coefficient k was 0.050.

The total number of layers of the first absorption film and the second absorption film was 14, and the total film thickness of the entire absorption film was 48.3 nm.

The EUV reflectivity in the absorption film region was 0.23%, and the OD value was 2.45.

### <Example 22>

A reflective photomask blank and a reflective photomask according to Example 22 were prepared in the same manner as in Example 1 except that the film thickness of the second absorption film (single layer) formed using tin oxide (SnO) and tantalum (Ta) was 15.8 nm, and the film thickness of the first absorption film (single layer) formed using niobium oxide (NbO) and silicon (Si) was 4.3 nm.

The refractive index n of the first absorption film was 0.95, and the extinction coefficient k was 0.015.

The refractive index n of the second absorption film was 0.95, and the extinction coefficient k was 0.050.

The total number of layers of the first absorption film and the second absorption film was 4, and the total film thickness of the entire absorption film was 40.2 nm.

The EUV reflectivity in the absorption film region was 0.51%, and the OD value was 2.11.

### <Example 23>

A reflective photomask blank and a reflective photomask according to Example 23 were prepared in the same manner as in Example 1 except that the film thickness of the second absorption film (single layer) formed using tin oxide (SnO) and tantalum (Ta) was 9.2 nm, and the film thickness of the first absorption film (single layer) formed using niobium oxide (NbO) and silicon (Si) was 2.5 nm.

The refractive index n of the first absorption film was 0.95, and the extinction coefficient k was 0.015.

The refractive index n of the second absorption film was 0.95, and the extinction coefficient k was 0.050.

The total number of layers of the first absorption film and the second absorption film was 8, and the total film thickness of the entire absorption film was 46.8 nm.

The EUV reflectivity in the absorption film region was 0.26%, and the OD value was 2.39.

### <Example 24>

A reflective photomask blank and a reflective photomask according to Example 24 were prepared in the same manner as in Example 1 except that the film thickness of the second absorption film (single layer) formed using tin oxide (SnO) and tantalum (Ta) was 4.4 nm, and the film thickness of the first absorption film (single layer) formed using niobium oxide (NbO) and silicon (Si) was 1.4 nm.

The refractive index n of the first absorption film was 0.95, and the extinction coefficient k was 0.015.

The refractive index n of the second absorption film was 0.95, and the extinction coefficient k was 0.050.

The total number of layers of the first absorption film and the second absorption film was 16, and the total film thickness of the entire absorption film was 40.2 nm.

The EUV reflectivity in the absorption film region was 0.25%, and the OD value was 2.41.

### <Example 25>

A reflective photomask blank and a reflective photomask according to Example 25 were prepared in the same manner as in Example 1 except that the film thickness of the second absorption film (single layer) formed using tin oxide (SnO) and tantalum (Ta) was 13.9 nm, and the film thickness of the first absorption film (single layer) formed using niobium oxide (NbO) and silicon (Si) was 1.7 nm.

The refractive index n of the first absorption film was 0.95, and the extinction coefficient k was 0.015.

The refractive index n of the second absorption film was 0.95, and the extinction coefficient k was 0.050.

The total film thickness of the entire absorption film was 46.8 nm.

The EUV reflectivity in the absorption film region was 0.22%, and the OD value was 2.47.

### <Example 26>

A reflective photomask blank and a reflective photomask according to Example 26 were prepared in the same manner as in Example 1 except that the film thickness of the second absorption film (single layer) formed using tin oxide (SnO) and tantalum (Ta) was 4.4 nm, and the film thickness of the first absorption film (single layer) formed using niobium oxide (NbO) and silicon (Si) was 2.2 nm.

The refractive index n of the first absorption film was 0.95, and the extinction coefficient k was 0.015.

The refractive index n of the second absorption film was 0.95, and the extinction coefficient k was 0.050.

The total number of layers of the first absorption film and the second absorption film was 12, and the total film thickness of the entire absorption film was 33.0 nm.

The EUV reflectivity in the absorption film region was 1.62%, and the OD value was 1.60.

### <Example 27>

A reflective photomask blank and a reflective photomask according to Example 27 were prepared in the same manner as in Example 1 except that the film thickness of the second absorption film (single layer) formed using lead (Pb) and tungsten (W) was 11.8 nm, and the film thickness of the first absorption film (single layer) formed using niobium oxide (NbO) and silicon (Si) was 2.0 nm.

The refractive index n of the first absorption film was 0.95, and the extinction coefficient k was 0.015.

The refractive index n of the second absorption film was 0.93, and the extinction coefficient k was 0.042.

The total film thickness of the entire absorption film was 41.4 nm.

The EUV reflectivity in the absorption film region was 1.19%, and the OD value was 1.73.

### <Example 28>

A reflective photomask blank and a reflective photomask according to Example 28 were prepared in the same manner as in Example 1 except that the film thickness of the second absorption film (single layer) formed using tin oxide (SnO) and tantalum (Ta) was 36.9 nm, and the film thickness of the first absorption film (single layer) formed using ruthenium (Ru) and silicon (Si) was 10.3 nm.

The refractive index n of the first absorption film was 0.90, and the extinction coefficient k was 0.015.

The refractive index n of the second absorption film was 0.95, and the extinction coefficient k was 0.050.

The total number of layers of the first absorption film and the second absorption film was 2, and the total film thickness of the entire absorption film was 47.2 nm.

The EUV reflectivity in the absorption film region was 0.24%, and the OD value was 2.43.

### <Example 29>

A reflective photomask blank and a reflective photomask according to Example 29 were prepared in the same manner as in Example 1 except that the film thickness of the second absorption film (single layer) formed using tin oxide (SnO) and tantalum (Ta) was 4.0 nm and the film thickness of the first absorption film (single layer) formed using ruthenium (Ru) was 3.9 nm.

The refractive index n of the first absorption film was 0.89, and the extinction coefficient k was 0.017.

The refractive index n of the second absorption film was 0.95, and the extinction coefficient k was 0.050.

The total number of layers of the first absorption film and the second absorption film was 10, and the total film thickness of the entire absorption film was 39.5 nm.

The EUV reflectivity in the absorption film region was 0.36%, and the OD value was 2.25.

In this example, the first absorption film was formed on the capping layer, and the second absorption film was formed on the first absorption film. That is, in this example, the absorption film was formed such that the second absorption film was an outermost layer.

### <Example 30>

A reflective photomask blank and a reflective photomask according to Example 30 were prepared in the same manner as in Example 1 except that the film thickness of the second absorption film (single layer) formed using tin oxide (SnO) and tantalum (Ta) was 16.9 nm, and the film thickness of the first absorption film (single layer) formed using aluminum (Al) and silicon (Si) was 5.5 nm.

The refractive index n of the first absorption film was 1.00, and the extinction coefficient k was 0.015.

The refractive index n of the second absorption film was 0.95, and the extinction coefficient k was 0.050.

The total number of layers of the first absorption film and the second absorption film was 4, and the total film thickness of the entire absorption film was 44.8 nm.

The EUV reflectivity in the absorption film region was 0.75%, and the OD value was 1.94.

### <Example 31>

A reflective photomask blank and a reflective photomask according to Example 31 were prepared in the same manner as in Example 1 except that the film thickness of the second absorption film (single layer) formed using tin oxide (SnO) and tantalum (Ta) was 10.8 nm, and the film thickness of the first absorption film (single layer) formed using tungsten (W) was 2.6 nm.

The refractive index n of the first absorption film was 0.93, and the extinction coefficient k was 0.033.

The refractive index n of the second absorption film was 0.95, and the extinction coefficient k was 0.050.

The total film thickness of the entire absorption film was 40.2 nm.

The EUV reflectivity in the absorption film region was 0.67%, and the OD value was 1.99.

Tungsten (W) used for the first absorption film is a material having hydrogen radical resistance.

### <Comparative Example 1>

A reflective photomask blank and a reflective photomask according to Comparative Example 1 were prepared in the same manner as in Example 1 except that the second absorption film was not provided and the film thickness of the first absorption film (single layer) formed using tin oxide (SnO) was 32.4 nm.

The refractive index n of the first absorption film was 0.93, and the extinction coefficient k was 0.070.

The total film thickness of the entire absorption film was 32.4 nm.

The EUV reflectivity in the absorption film region was 0.20%, and the OD value was 2.51.

### <Comparative Example 2>

A reflective photomask blank and a reflective photomask according to Comparative Example 2 were prepared in the same manner as in Example 1 except that the film thickness of the second absorption film (single layer) formed using tin oxide (SnO) and zirconium (Zr) was 18.5 nm, and the film thickness of the first absorption film (single layer) formed using niobium oxide (NbO) and silicon (Si) was 1.6 nm.

The refractive index n of the first absorption film was 0.95, and the extinction coefficient k was 0.015.

The refractive index n of the second absorption film was 0.95, and the extinction coefficient k was 0.030.

The total number of layers of the first absorption film and the second absorption film was 4, and the total film thickness of the entire absorption film was 40.2 nm.

The EUV reflectivity was 5.19%, and the OD value was 1.10.

### <Reference Example>

A reflective photomask blank and a reflective photomask according to Reference Example are a conventional tantalum (Ta) mask blank and a conventional tantalum (Ta) mask according to the related art.

The reflective photomask blank and the reflective photomask according to Reference Example were prepared in the same manner as in Example 1 except that the second absorption film was not provided and the film thickness of the first absorption film (single layer) formed using tantalum nitride (TaN) and tantalum oxide (TaO) was 60 nm.

The refractive index n of the first absorption film was 0.95, and the extinction coefficient k was 0.030.

The total film thickness of the entire absorption film was 60.0 nm.

The EUV reflectivity in the absorption film region was 1.83%, and the OD value was 1.54.

### <Evaluation>

The reflective photomasks obtained in Examples 1 to 31, Comparative Examples 1 and 2, and Reference Example described above were evaluated for the EUV reflectivity, the OD value, and hydrogen radical resistance by the following methods.

### [EUV reflectivity]

In the present example, the EUV reflectivity of 1.80% or less obtained by measurement was regarded as acceptable because the performance was improved compared with that of the conventional tantalum (Ta) mask.

### [OD Value]

In the present example, the OD value of 1.5 or more obtained by measurement was regarded as acceptable because it causes no problem in use.

### [Hydrogen Radical Resistance]

Hydrogen was excited at a flow rate of 100 sscm using 2.45 GHz microwave plasma (MWP), and the prepared reflective photomask was placed on one of electrodes with an interelectrode distance of 18 mm. A change in the film thickness of the absorption film after a hydrogen radical treatment was confirmed using an atomic force microscope (AFM) and evaluated in three levels of double circle (⊚), circle (○), and cross (×) below. Measurement was performed on an L/S pattern with a line width of 200 nm.

In the present example, "double circle (⊚)" and "circle (○)" were regarded as acceptable.

### <Evaluation Criteria>

Double circle (⊚): No change in film thickness with respect to hydrogen radicals was observed
Circle (○): A slight change in film thickness with respect to hydrogen radicals was observed
Cross (×): A change in film thickness with respect to hydrogen radicals was observed

The above evaluation results are shown in Table 1.

**[Table 1]**

| | First absorption film | | | | Second absorption film | | | | Number of layers | Total film thickness (nm) | EUV reflectivity | OD | Hydrogen radical resistance |
|---|---|---|---|---|---|---|---|---|---|---|---|---|---|
| | Material | n | k | Film thickness (nm) | Material | n | k | Film thickness (nm) | | | | | |
| Example 1 | TaO | 0.96 | 0.027 | 1.9 | SnO + Ta | 0.95 | 0.050 | 11.4 | 6 | 39.9 | 0.70% | 1.96 | ○ |
| Example 2 | SiO | 0.97 | 0.013 | 2.5 | SnO + Ta | 0.95 | 0.050 | 11.1 | 6 | 40.8 | 0.74% | 1.94 | ○ |
| Example 3 | TiO | 0.94 | 0.022 | 2.5 | SnO + Ta | 0.95 | 0.050 | 10.9 | 6 | 40.2 | 0.63% | 2.01 | ○ |
| Example 4 | NbO | 0.95 | 0.010 | 2.4 | SnO + Ta | 0.95 | 0.050 | 11.0 | 6 | 40.2 | 0.61% | 2.02 | ○ |
| Example 5 | CrO | 0.93 | 0.033 | 2.6 | SnO + Ta | 0.95 | 0.050 | 10.8 | 6 | 40.2 | 0.67% | 1.99 | ○ |
| Example 6 | HfO | 0.95 | 0.034 | 2.2 | SnO + Ta | 0.95 | 0.050 | 11.1 | 6 | 39.9 | 0.72% | 1.95 | ○ |
| Example 7 | Ru | 0.89 | 0.017 | 2.6 | SnO + Ta | 0.95 | 0.050 | 10.4 | 6 | 39.0 | 0.71% | 1.96 | ○ |
| Example 8 | Mo | 0.92 | 0.006 | 2.4 | SnO + Ta | 0.95 | 0.050 | 11.0 | 6 | 40.2 | 0.37% | 2.25 | ○ |
| Example 9 | Zr | 0.96 | 0.004 | 2.1 | SnO + Ta | 0.95 | 0.050 | 11.3 | 6 | 40.2 | 0.54% | 2.08 | ○ |
| Example 10 | NbO + Si | 0.95 | 0.015 | 2.2 | In + Ta | 0.94 | 0.058 | 11.5 | 6 | 41.1 | 0.13% | 2.71 | ○ |
| Example 11 | NbO + Si | 0.95 | 0.015 | 2.4 | Ni + Ta | 0.95 | 0.053 | 11.2 | 6 | 40.8 | 0.44% | 2.17 | ○ |
| Example 12 | NbO + Si | 0.95 | 0.015 | 2.3 | Te + Ta | 0.96 | 0.057 | 10.9 | 6 | 39.6 | 0.20% | 2.51 | ○ |
| Example 13 | NbO + Si | 0.95 | 0.015 | 2.6 | Ag + Ta | 0.92 | 0.060 | 11.4 | 6 | 42.0 | 0.06% | 3.05 | ○ |
| Example 14 | NbO + Si | 0.95 | 0.015 | 2.4 | Co + Ta | 0.94 | 0.051 | 11.1 | 6 | 40.5 | 0.55% | 2.07 | ○ |
| Example 15 | NbO + Si | 0.95 | 0.015 | 2.5 | Sb + Ta | 0.94 | 0.053 | 11.1 | 6 | 40.8 | 0.41% | 2.20 | ○ |
| Example 16 | NbO + Si | 0.95 | 0.015 | 2.5 | Bi + Ta | 0.94 | 0.049 | 11.1 | 6 | 40.8 | 0.70% | 1.97 | ○ |
| Example 17 | NbO + Si | 0.95 | 0.015 | 2.0 | Ir + Ta | 0.93 | 0.043 | 11.8 | 6 | 41.4 | 1.13% | 1.76 | ○ |
| Example 18 | NbO + Si | 0.95 | 0.015 | 2.0 | Re + Ta | 0.93 | 0.040 | 11.7 | 6 | 41.1 | 1.57% | 1.61 | ○ |
| Example 19 | NbO + Si | 0.95 | 0.015 | 2.1 | Pt + Ta | 0.92 | 0.050 | 11.9 | 6 | 42.0 | 0.38% | 2.24 | ○ |
| Example 20 | NbO + Si | 0.95 | 0.015 | 2.0 | Os + Ta | 0.93 | 0.042 | 11.8 | 6 | 41.4 | 1.19% | 1.73 | ○ |
| Example 21 | NbO + Si | 0.95 | 0.015 | 3.5 | SnO + Ta | 0.95 | 0.050 | 3.4 | 14 | 48.3 | 0.23% | 2.45 | ○ |
| Example 22 | NbO + Si | 0.95 | 0.015 | 4.3 | SnO + Ta | 0.95 | 0.050 | 15.8 | 4 | 40.2 | 0.51% | 2.11 | ○ |
| Example 23 | NbO + Si | 0.95 | 0.015 | 2.5 | SnO + Ta | 0.95 | 0.050 | 9.2 | 8 | 46.8 | 0.26% | 2.39 | ○ |
| Example 24 | NbO + Si | 0.95 | 0.015 | 1.4 | SnO + Ta | 0.95 | 0.050 | 4.4 | 16 | 40.2 | 0.25% | 2.41 | ○ |
| Example 25 | NbO + Si | 0.95 | 0.015 | 1.7 | SnO + Ta | 0.95 | 0.050 | 13.9 | 6 | 46.8 | 0.22% | 2.47 | ○ |
| Example 26 | NbO + Si | 0.95 | 0.015 | 2.2 | SnO + Ta | 0.95 | 0.050 | 4.4 | 12 | 33.0 | 1.62% | 1.60 | ○ |
| Example 27 | NbO + Si | 0.95 | 0.015 | 2.0 | Pb+W | 0.93 | 0.042 | 11.8 | 6 | 41.4 | 1.19% | 1.73 | ○ |
| Example 28 | Ru + Si | 0.90 | 0.015 | 10.3 | SnO + Ta | 0.95 | 0.050 | 36.9 | 2 | 47.2 | 0.24% | 2.43 | ○ |
| Example 29 | Ru | 0.89 | 0.017 | 3.9 | SnO + Ta | 0.95 | 0.050 | 4.0 | 10 | 39.5 | 0.36% | 2.25 | ○ |
| Example 30 | Al + Si | 1.00 | 0.015 | 5.5 | SnO + Ta | 0.95 | 0.050 | 16.9 | 4 | 44.8 | 0.75% | 1.94 | ○ |
| Example 31 | w | 0.93 | 0.033 | 2.6 | SnO + Ta | 0.95 | 0.050 | 10.8 | 6 | 40.2 | 0.67% | 1.99 | ○ |
| Comparative Example 1 | SnO | 0.93 | 0.070 | 32.4 | - | - | - | - | - | 32.4 | 0.20% | 2.51 | × |
| Comparative Example 2 | NbO + Si | 0.95 | 0.015 | 1.6 | SnO + Zr | 0.95 | 0.030 | 18.5 | 4 | 40.2 | 5.19% | 1.10 | ○ |
| Reference Example | TaN + TaO | 0.95 | 0.03 | 60 | - | - | - | - | - | 60.0 | 1.83% | 1.54 | ○ |

As shown in Table 1, based on the evaluation results of Examples 1 to 31, Comparative Examples 1 and 2, and Reference Example, a reflective photomask blank and a reflective photomask having high resistance to hydrogen radicals, low EUV reflectivity, and a high OD value can be provided when the reflective photomask blank and the reflective photomask have a configuration in which the absorption film is formed by alternately depositing the first absorption film and the second absorption film, the first absorption film has excellent hydrogen radical resistance, the extinction coefficient k or the refractive index n of the first absorption film is different from the extinction coefficient k or the refractive index n of the second absorption film, and the extinction coefficient k of the second absorption film is 0.04 or more.

The reflective photomask blank and the reflective photomask according to the present invention are not limited to the embodiment and the examples described above, and various modifications can be made within a range that does not impair the features of the invention.

### REFERENCE SIGNS LIST

1: substrate (low thermal expansion film)
2: multilayer reflective film
3: capping layer
4: reflective layer
5: low-reflective portion (absorption film)
5a: low-reflective portion pattern
51: first absorption film
52: second absorption film
52a: passivation layer
6: backside conductive film
10: reflective photomask blank (reflective mask blank)
20: reflective photomask (reflective mask)
300: chamber
301: electrode
302: sample

## Claims

1. A reflective mask blank used for producing a reflective mask for pattern transfer using extreme ultraviolet light as a light source, the reflective mask blank at least comprising:
a substrate;
a multilayer film formed on the substrate;
a capping film formed on the multilayer film configured to protect the multilayer film; and
an absorption film formed on the capping film, wherein
the absorption film is formed by alternately depositing a first absorption film and a second absorption film,
the first absorption film has high hydrogen radical resistance,
an extinction coefficient or a refractive index of the first absorption film is different from an extinction coefficient or a refractive index of the second absorption film, and
the extinction coefficient of the second absorption film with respect to EUV light is 0.04 or more.

2. The reflective mask blank according to claim 1, wherein
the first absorption film comprises one or more elements selected from tantalum, silicon, titanium, niobium, chromium, hafnium, ruthenium, molybdenum, aluminum, and zirconium.

3. The reflective mask blank according to claim 1, wherein
the second absorption film comprises one or more elements selected from tin, indium, platinum, nickel, tellurium, silver, cobalt, tantalum, antimony, bismuth, osmium, iridium, and rhenium.

4. The reflective mask blank according to claim 1, wherein
a total film thickness of the absorption film is 47 nm or less.

5. The reflective mask blank according to claim 1, wherein
the number of layers of the first absorption film and the second absorption film is four or more.

6. The reflective mask blank according to claim 1, wherein
an outermost layer of the absorption film is the first absorption film.

7. The reflective mask blank according to claim 1, wherein
an optical density (OD) value calculated based on the absorption film and the multilayer film is 1.5 or more.

8. A reflective mask at least comprising:
a substrate;
a multilayer film formed on the substrate;
a capping film formed on the multilayer film configured to protect the multilayer film; and
an absorption film formed on the capping film and patterned, wherein
the absorption film is formed by alternately depositing a first absorption film and a second absorption film,
the first absorption film has high hydrogen radical resistance,
an extinction coefficient or a refractive index of the first absorption film is different from an extinction coefficient or a refractive index of the second absorption film, and
the extinction coefficient of the second absorption film with respect to EUV light is 0.04 or more.

9. The reflective mask according to claim 8, wherein
the first absorption film comprises one or more elements selected from tantalum, silicon, titanium, niobium, chromium, hafnium, ruthenium, molybdenum, aluminum, and zirconium.

10. The reflective mask according to claim 8, wherein
the second absorption film comprises one or more elements selected from tin, indium, platinum, nickel, tellurium, silver, cobalt, tantalum, antimony, bismuth, osmium, iridium, and rhenium.

11. The reflective mask according to claim 8, wherein
a total film thickness of the absorption film is 47 nm or less.

12. The reflective mask according to claim 8, wherein
the number of layers of the first absorption film and the second absorption film is four or more.

13. The reflective mask according to claim 8, wherein
an outermost layer of the absorption film is the first absorption film.

14. The reflective mask according to claim 8, wherein
an optical density (OD) value calculated based on the absorption film and the multilayer film is 1.5 or more.

15. The reflective mask according to claim 8, wherein
an oxide film having high hydrogen radical resistance is formed on a sidewall of the second absorption film that is patterned.
